# EUROPEAN PATENT SPECIFICATION

(11) **EP 1 782 426 B1**
(45) Date of publication and mention of the grant of the patent: **28.10.2015**
(21) Application number: 05770835.6
(22) Date of filing: 11.07.2005
(51) Int. Cl.: G11C 16/34, G11C 16/10, G11C 29/02, G11C 29/50, G11C 16/04

(54) **SELF-ADAPTIVE PROGRAM DELAY CIRCUITRY FOR PROGRAMMABLE MEMORIES**
SELBSTADAPTIVE PROGRAMMVERZÖGERUNGS-SCHALTKREISE FÜR PROGRAMMIERBARE SPEICHER
CIRCUIT A RETARD DE PROGRAMME AUTO-ADAPTATIF POUR MEMOIRES PROGRAMMABLES

(30) Priority: 17.08.2004 FR 0408930; 16.11.2004 US 990203
(43) Date of publication of application: 09.05.2007
(73) Proprietor: Atmel Corporation, San Jose, CA 95110 (US)
(72) Inventor: COMBE, Marylene, F-13790 Rousset (FR); DAGA, Jean-Michel, F-13790 Rousset (FR)
(74) Representative: Grünecker Patent- und Rechtsanwälte PartG mbB
(86) International application number: PCT/US2005/024187
(87) International publication number: WO 2006/023146

(56) References cited:
- US-A- 5 386 388
- US-A- 5 467 309
- US-A- 5 537 358
- US-A- 5 537 358
- US-A- 5 751 637
- US-A- 6 032 248
- US-A1- 2004 042 284
- US-B1- 6 191 976
- US-B1- 6 191 976
- US-B1- 6 292 394
- US-B1- 6 418 054
- US-B1- 6 418 054
- US-B1- 6 829 181
- PATENT ABSTRACTS OF JAPAN vol. 018, no. 315 (P-1755), 15 June 1994 (1994-06-15) & JP 06 068686 A (HITACHI LTD; others: 01), 11 March 1994 (1994-03-11)

## Description

### FIELD OF THE INVENTION

The present invention relates to integrated circuit memory architectures. More specifically, the invention relates to a new programming operation protocol and memory architecture for programmable memories allowing "intelligent programming."

### BACKGROUND ART

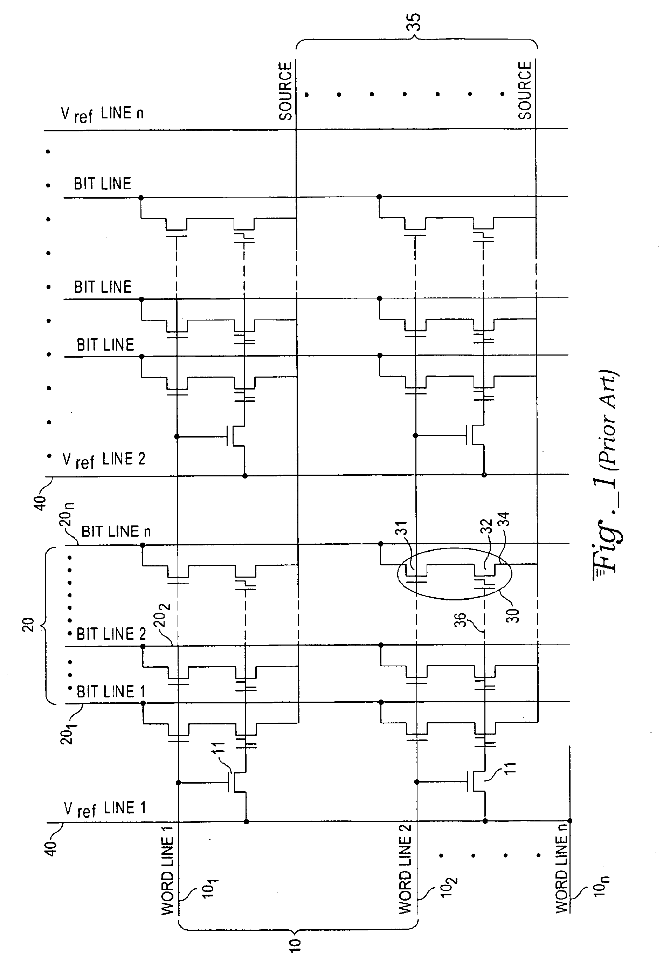

Figure 1 shows the array architecture of a programmable EEPROM memory, based on a matrix of rows and columns. Each row and each column correspond to a plurality of word lines 10₁, 10₂, ..., 10ₙ, and a plurality of bit lines 20₁, 20₂, ...,20ₙ, (bits are accessible at 2ⁿ bits per word) respectively. An exemplary memory cell 30 is located on each word line 10 and bit line 20 intersection. The memory cell 30 is composed of a select transistor 31 and a floating gate transistor 32 connected in series. The gate of the cell select transistor 31 is connected to the word line10, its drain to the bit line 20, and its source to the drain of the floating gate transistor 32. A floating gate transistor source 34 is connected to ground via source line 35, and the floating gate transistor's gate 36 may be logically connected to a Vref line 40 when enabled by a word select device 11.

Data storage in a floating gate transistor is obtained by varying electrical charge that exists on the floating gate. To obtain a logical 1 value (erased state), electrons must be injected into the floating gate, which increases the threshold voltage of the floating gate transistor 32. To obtain a logical 0 value (written state), electrons must be extracted from the floating gate, which decreases the threshold voltage of the floating gate transistor 32. A mechanism referred to as Fowler Nordheim Tunneling is used for both erase and program operations on an EEPROM memory. This mechanism is very slow (in the millisecond range) and requires a high voltage source Vₚₚ that is generated by a circuit within the EEPROM memory chip. The V_{ref} line 40 is driven to Vₚₚ during an erase operation and grounded during a write operation. The bit line 20 is left floating during an erase operation and connected to Vₚₚ during a write operation.

Erasing a cell is obtained by applying a high voltage Vₚₚ on the gate 36 of the floating gate transistor 32 (via word select device 11 and V_{ref} line 40), and ground to the floating gate transistor's source 34 (by grounding source lines 35). To write the memory cell 30, Vₚₚ must be applied to the drain of the floating gate transistor 32 (via bit line 20 and cell select transistor 31), the floating gate transistor's gate 36 must be grounded (via word select device 11 and V_{ref} line 40), and the floating gate transistor's source 34 is left floating (by floating source lines 35).

If memory cells 30 share the same V_{ref} line 40, multiple memory cells may be grouped into words and may be erased in parallel. Also, each bit (memory cell) may be written independently by driving its corresponding bit line 20 to Vₚₚ.

Word programming is obtained in two steps. First the word is erased and all of the erased bits are set to a logic 1 value after erase. Secondly, all of the necessary bits in the word are written at the same time, changing all bits to a logic 0 value in order to program the targeted word data.

With reference to Figure 1, depending on the threshold voltage (Vₜₕ) of the floating gate transistor 32, each memory cell 30 will be conducting or not conducting current. If the threshold voltage Vₜₕ is higher than the reference voltage V_{ref}, the memory cell 30 is OFF. If Vₜₕ is lower than V_{ref}, the memory cell 30 is ON. A threshold voltage Vₜₕ may be adjusted by injecting or removing electrons from the floating gate of each floating gate transistor 32 during a memory cell 30 or word programming operation. During an erase operation, electrons are injected into the floating gate resulting in a high threshold voltage value V_{thhigh}. During a write operation, electrons are removed from the floating gate, resulting in a low threshold voltage V_{thlow}. The difference between the high V_{thhigh} and the low V_{thlow} is referred to as a program window. The reference voltage value normally applied to the gate of a memory cell 30 during a read operation is between V_{thhigh} and V_{thlow}. Due to a possible charge loss from the floating gate, after for example several years, a wide program window is desirable to prevent possible data loss.

The data retention characteristics of each memory cell 30 will depend on a capability of the memory cell 30 to reliably maintain voltage thresholds over time, due to an intrinsic floating gate charge loss. In addition, characteristics of a memory cell 30 may change after several erase and write cycles, resulting from a negative charge trapping phenomenon. These technical characteristics of the memory cell 30 make it difficult to guarantee an acceptable data retention capability.

Therefore, it is desirable to have a program window that is as wide as possible to compensate for characteristics of a programmable memory cell that may affect the integrity of data stored within a memory cell.

US 6,292,394 B1 discloses a method for programming or erasing an array having multiplicity of memory cells. The method includes, per cell to be programmed, verifying a programmed or non-programmed state of the cell and flagging those of the cells that verify as non-programmed during one of the verify steps after having previously verified as programmed. A programming pulse having a programming level is applied to the non-programmed cells which are not flagged cells. The steps of verifying, flagging and applying are then repeated until all of the cells verify as programmed at least once. Subsequently, a boost pulse having a boost programming level lower than the programming level is applied to the flagged cells. Further, this document specifies that the programming pulse can vary in length of time or the voltage level of the programming pulse can be increased.

US 6,191,976 B1 discloses structures and methods to improve programming margins. The proposed Flash memory sense amplifier reference circuit has weighted dummy loads which are used to balance and bias the sense amplifier during erasing, programming and verification such that the resulting robust stored logic state can meet more stringent pass-fail verify "1" or verify "0" tests. Programming in this manner guarantees logic states which meet full operating temperature and full power supply tolerances requirements.

In addition, US 5,751,637 presents an automatic programming algorithm for page mode flash memory with variable programming pulse height and pulse width. The disclosed method insures fast programming to substantially all of the cells in the array, without over-programming, based on providing a pattern of program retry pulses which have respective pulse widths and pulse heights which vary according to a pattern. The pattern includes a combination of both increasing pulse widths and increasing pulse heights.

US 2004/0042284 A1 discloses a flash memory for improving write access time. The comparator circuit used in this document receives 32-bit data from an addressed block of a memory cell array. Further, the comparator circuit also receives 32-bit data from a page buffer and compares the data received from the page buffer with the data received from the memory cell array to generate a write enable signal and a write error detection signal.

### BRIEF DESCRIPTION OF THE DRAWINGS

Figure 1 is example of an EEPROM memory array of the prior art.
Figure 2 is a block diagram of an EEPROM memory array (memory core) with additional exemplary circuitry used for a self-adaptive programming operation.
Figure 3 is a column latch circuit associated with a self-adaptive programming operation of Figure 2.
Figure 4 is the column latch of Figure 3 with an exemplary verify function.
Figure 5 is the column latch of Figure 4, with an exemplary selective Vref column latch.
Figure 6 is a flow chart illustrating functions of an exemplary erase algorithm associated with a self-adaptive programming operation.
Figure 7 is a flow chart illustrating functions of an exemplary write algorithm associated with a self-adaptive programming operation.

### SUMMARY OF THE INVENTION

The invention is defined in claims 1 and 17, respectively. Particular embodiments of the invention are set out in the dependent claims.

The present invention is a circuit to produce an automatically tuned programming pulse to compensate for a negative charge trapping phenomenon in the oxide of a floating gate transistor and to compensate for low supply voltage and temperature changes. The programming pulse is tuned according to programming conditions such as temperature and supply voltage. The memory is controlled as necessary to provide improved data reliability under a variety of conditions such as temperature and the number of times the floating gate transistor has been programmed. Using the tuned programming pulse results in better data retention capability even when using a part that has been repeatedly programmed. In addition, because the programming pulse is optimized, the power consumption is also optimized and the memory is stressed less. The present invention is also a method to program and verify a memory cell, using a read voltage that is different than a normal read voltage, after either an erase operation or write operation, and automatically adjusting the parameters of the programming pulse.

### BEST MODE FOR CARRYING OUT THE INVENTION

The present invention is a self-adaptive programming operation that tunes the programming pulse delay time used in an erase or write operation, based on a read operation and comparison to an expected logic value for the memory cell 30. Erase and write delays are tuned automatically to maintain an acceptable program window under a variety of conditions. Increasing the programming pulse delay on a cycled part is a method used to recover an acceptable program window and to recover desired memory cell retention characteristics. For example, another programming pulse is applied after a comparison failure, when charges trapped in the oxide of the floating gate transistor 32 make the programming mechanism less efficient. Endurance, data retention, and power consumption characteristics may also be improved by the present invention.

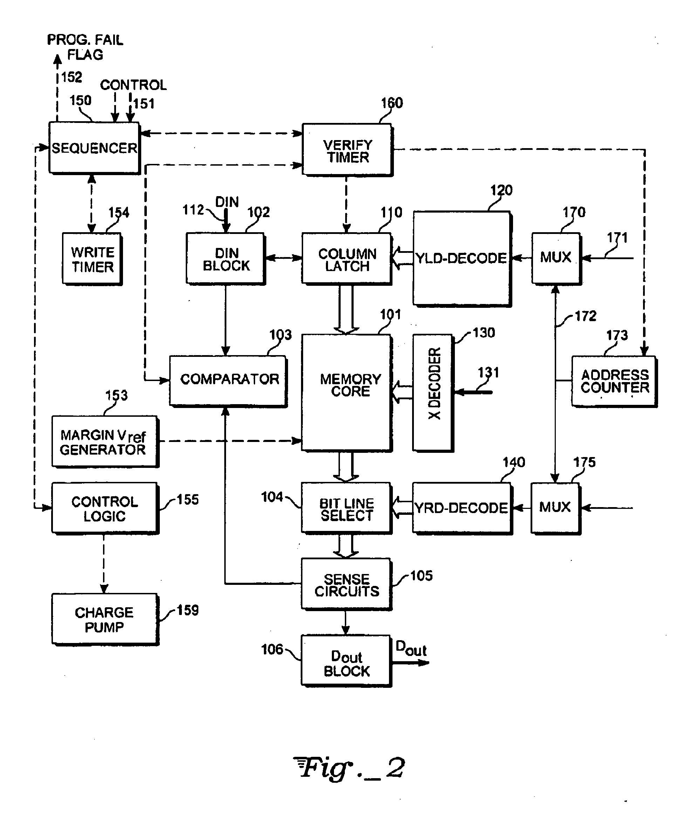

In an exemplary embodiment of the present invention, an automatic tuning of the number of programming pulses increases to compensate for an erase operation or write operation failure of any memory cell within a programmable EEPROM memory. With reference to Figure 2, exemplary EEPROM memory device that contains a memory core 101, a "data in" block 102, a bit line select 104, column latch 110, address decoders 120, 130, 140, sense circuits 105, a charge pump 159, control logic 155, control lines 151, and a write timer 154. In addition, a program failure flag 152, a dedicated sequencer 150, dedicated latch circuitry, a verify timer 160, an address counter 173, multiplexers 170, 175, comparator 103, and a margin reference voltage (V_{ref}) generator 153 are necessary to implement the self-adaptive programming. The memory core 101 represents an array architecture similar to the array architecture of an EEPROM memory as shown in Figure 1.

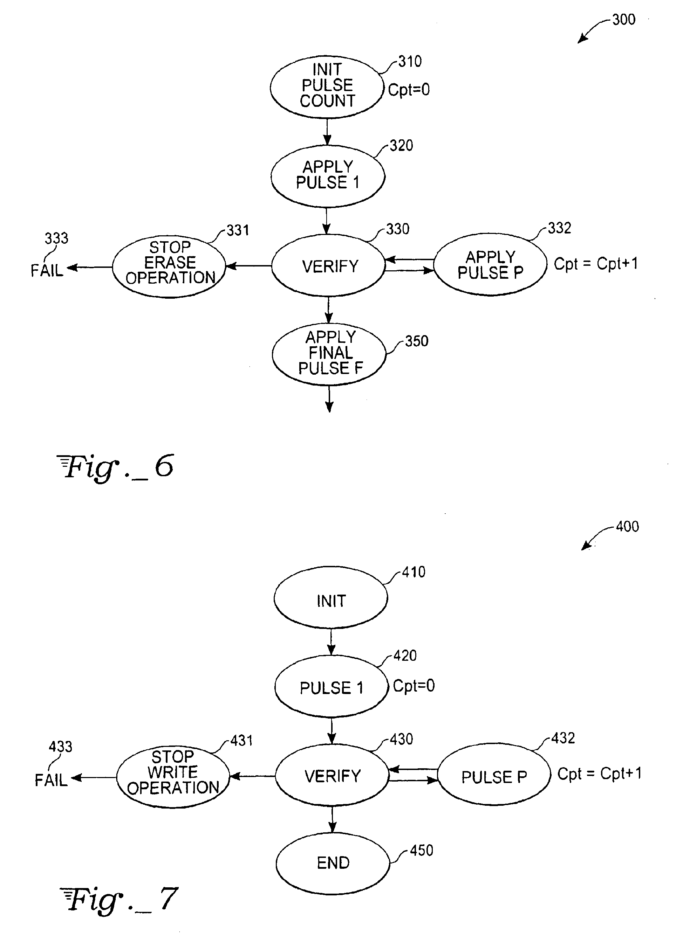

In the exemplary embodiment, sequencer 150 is a state machine used to implement an embodiment of a programming algorithm (details of the programming algorithm are described in detail with respect to Figures 6 and 7). In alternate embodiments, the functions of a sequencer 150 may be performed by a dedicated controller or by a processor. The sequencer 150 is connected to control logic 155, and to write timer 154. The control logic 155 turns charge pump 159 on or off to provide voltage Vₚₚ. The write timer 154 controls a programming pulse width. The sequencer 150 delivers erase and write pulses to the write timer 154. During a verification operation, the address counter 173 generates a required addresses beginning at a first address. Addresses are provided to the YLD 20 and YRD 40 address decoders via multiplexers 170, 175. Any erased memory cell 30 should be equal to a logic 1 value. An erased word logic value should be equal to a group of 2ⁿ bits, each bit having a logical 1 value. For example, an eight bit word should have a hex value of FF after an erase operation. The comparator 103 also compares a memory cell 30 or word in the memory array that has been written to the content of column latches containing an expected data or logic value.

The content of at least one programmed memory cell 30 is verified automatically (see further details below) and a programming operation is completed when a verification of a programmed memory cell 30 is successful. A read margin mode test is used to verify the quality of a programming operation. A margin voltage reference is used in a read margin mode test. The voltage reference V_{ref} is increased when reading OFF cells and decreased when reading ON cells and comparison to a normal read voltage reference. For example, a margin of approximately ±0.5 volts is used. Using a margin voltage reference during a read operation guarantees that the memory cell stays OFF when memory cell 30 is read with Vref+0.5V on its gate, and the memory cell stays ON when memory cell 30 is read with Vref-0.5V on its gate. During a verification operation, a word in the memory core (array) 101 is read using a margin mode by applying an internally generated V_{ref} value by the margin V_{ref} generator 153.

A programming operation that programs a logic value in at least one memory cell 30 is divided in three phases or operations: load, erase, and write.

Programming current for a single cell is very small, making programming several bits in parallel possible. To improve the programming speed of EEPROM memory, it is possible to erase or write several words in the same row or multiple words in a page at the same time. However, the data to be programmed must be loaded into a dedicated buffer (latch) before starting a parallel write operation. A column latch 110 buffer system is composed of one column latch 110 per bit line 20 and one column latch per V_{ref} line 40. In an exemplary embodiment, there is a column latch 110 for each bit line 20 and a column latch 110 for each V_{ref} line 40. A memory core 101 having a column latch 110 coupled to each bit line provides an erasure operation by word (one or more bits), and a selective write operation (by bit or by word).

The column latch 110 provides two functions. The column latch stores data and also brings Vₚₚ to a corresponding bit line 20. Data to be programmed into a memory cell 30 is loaded into at least one column latch 110. A group of 2ⁿ bit latches and one V_{ref} latch (or byte flag) store the data to be programmed on a targeted row. During a load operation, the Yaddress bus AddYld 171 is decoded by the Yld-decoder 120. A data value is loaded into at least one word of column latches 110 coupled to the bit lines 20. A logical value (flag signal) is also stored in an associated V_{ref} column latch. Words that will be used to program memory cells 30 are selected by using the flag signal loaded into the associated V_{ref} column latches 110. Word lines are selected by an Xaddress on Xdecoder input 131, which is decoded by an Xdecoder 130. When all of the data words have been loaded, erase voltages are applied on selected words.

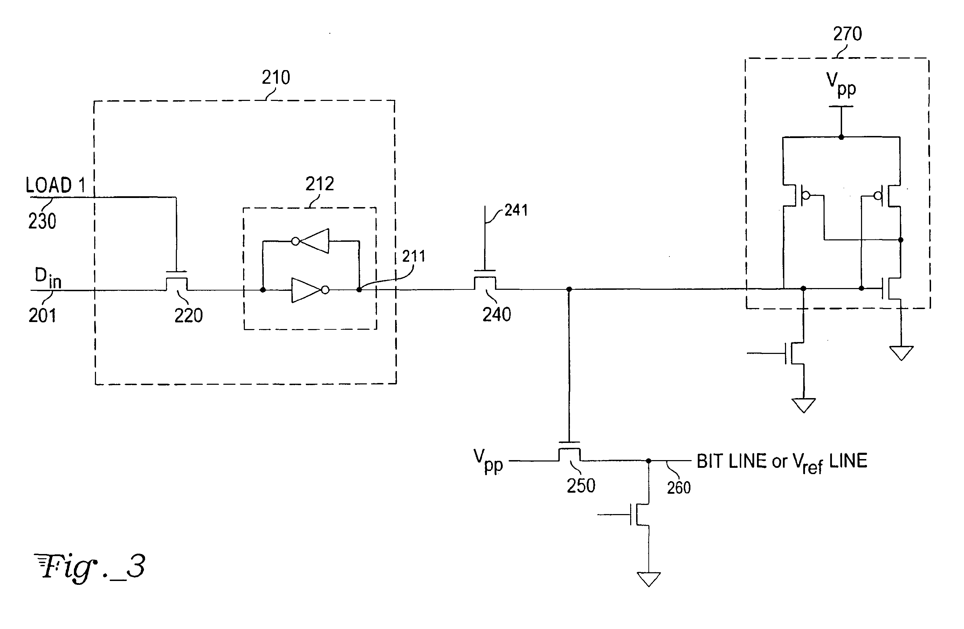

The latch circuit may be incorporated into the column latch 110 block shown in Figure 2. Figure 3 illustrates circuits disclosed in U.S. Patent Application No. 10/737,676 (Patent No. US 6,859,391 B1) titled "EEPROM Architecture and Programming Protocol" that may be used in an embodiment of the present invention. The latch circuit comprises a pass transistor and a pair of feedback inverters to provide a state latch 210 operation. Column latch 210 may be used during an erase operation and/or a memory write operation. The column latch circuit 210 includes a state latch 212 and a state latch pass transistor 220 that is controlled by a load control signal applied to a gate 230 of the state latch pass transistor 220. In addition, the column latch circuit 210 includes circuitry to provide reference and programming voltages Vₚₚ. Data control pass gate 240 is coupled to the latch output 211, and controlled by a data control input 241. The data control pass gate 240 is coupled to a level shift circuit 270 to provide a voltage to the memory array different than the voltage used in the state latch circuit 210. The data control pass gate 240 is also coupled to a Vₚₚ pass gate 250 to apply a Vₚₚ voltage to a column (bit line 20).

During the load period, an input data on input Din 201 is input to the column latches 110 using the Yld decoder 120. A load control signal is applied to a gate 230 of the state latch pass transistor 220 is set to a logic 1 value in order to latch a data input value via Din 201 into at least one state latch 212. The loaded data is a logic 1 value to program a memory cell 30 that is OFF, and a logic 0 value to program a memory cell 30 that is ON. In addition, a logic 1 value is loaded into a V_{ref} latch corresponding to each word to be programmed. The loading period ends when all the words at each desired address have been loaded one by one into each latch that corresponds to a memory cell 30 targeted for a programming operation. Address counter 173 is used to count or increment a memory core address as part of a verify operation. AddYint 172 may start from address location 1, and is decoded by both the load and read decoders 120, 140.

Next after completing a load operation, memory cells 30 are erased as 2ⁿ bit words in parallel. In the erasure stage, electrons are injected into the floating gate structure by holding the gates of floating gate transistor 32 (in Figure 1) at an elevated voltage Vₚₚ. A Vₚₚ voltage is provided by at least one V_{ref} column latch through the word select pass gate 11. To implement an erase operation, the X Decoder 130 as shown in Figure 2 applies Vₚₚ on a word line corresponding to an AddX address (corresponding to word line 11 in Figure 1). The data control pass transistor 240 is toggled ON, the V_{ref} column latch 210 drives or turns the (voltage) level shifter circuit 270 on, and applies Vₚₚ via bit line pass transistor 250 to the control V_{ref} line(s) 40.

The required erase voltage Vₚₚ is applied as a pulse having an applied duration. The applied duration is referred to as an erase time delay Tₑᵣₐₛₑ. Application of the Vₚₚ voltage pulse causes electrons to accelerate to the selected floating gates 320. The increase in electrons that are held in the floating gate increases the cell's voltage threshold Vₜₕ. The selected words are then erased and each selected bit is set to a logic value of 1. After the erase operation is completed, an erase verification operation is executed 300 as illustrated by the exemplary algorithm in Figure 6 (described further below).

After an erase operation is completed, a write operation may be executed. During a write operation, the X decoder 130 (via word select device 11) applies Vₚₚ on the word line(s) 10 selected by AddX on Xdecoder input 131. As shown in Figure 3, Vₚₚ pass transistor 250, controlled by column latch 210 and applying a control signal 241 to the gate of pass transistor 240, applies Vₚₚ to bit lines 20 (in Figure 1) that have been selected. In each column latch 210, the content of each state latch is connected to the input of the level shift circuit 270 when the data control pass transistor 240 turns ON by driving the data control input 201. If the state value of latch output 211 is a logic value 0, then the gate of Vₚₚ pass gate 250 retains a logic 0 value, and the bit line 260 is left floating. In the case when the state latch output 211 is a logic value 0, a corresponding memory cell is not written, and remains at a logic 1 value after an erase operation has been completed. If the state latch output 211 is a logic value 1, then Vₚₚ pass gate 250 is switched to Vₚₚ by level shift circuit 270. In the case when the state latch output 211 is a logic value 1, Vₚₚ pass gate 250 is conducting, and voltage Vₚₚ is transmitted to bit line(s) 260. The selected memory cell is written and a logic value of the memory cell is changed to a logic 0 value.

When the write operation is completed, the write operation is then automatically verified. The written memory cell 30 is read and its value is compared with an expected data value stored in a corresponding latch.

A verification operation is performed after an erase operation or after a write operation has been performed. A verification operation reads at least one memory cell 30 and compares the contents of the memory cell 30 with an expected value. For an erase operation, the expected value of each memory cell is a logical 1 value. An erased word logic value should be equal to a group of 2ⁿ bits, each bit having a logical 1 value. For example, an eight bit word should have a hex value of FF after an erase operation. Erased words, for example, will be compared to the value FF. For a write operation, an expected value is the logical value that is stored in the column latch 110, 210 associated with each memory cell 30. Both the logical value that is stored in at least one column latch 110, 210 and the value that is stored in at least one memory cell 30 are read. When verifying a write operation, the logic value of the memory cell 30 is compared to the logic value that is stored in the corresponding column latch 110, 210.

In a memory cell 30 read operation, a reference voltage V_{ref} is applied to the gate of floating gate transistor 32. The reference voltage may be a normal reference voltage or a margin reference voltage. The drain current of floating gate transistor 32, measured by sense circuits 105 (in Figure 2) indicates whether there are stored electrons in the floating gate of the floating gate transistor 32. A programmed cell draws less drain current than a reference cell indicating a stored logic 0 value.

In an exemplary embodiment of a read operation, a reference voltage V_{ref} is applied via word select device 11 to the gate 36 of each selected floating gate transistor 32. Additionally, voltage V_{dd} is applied to the gate of select transistor 31. A floating gate transistor 32 is selected by an activated word line 10 and by activated bit line 20. The bit lines 20 are connected to sense circuits 105 through the bit line select circuit 104. In an alternate embodiment for low voltage applications, twice the V_{dd} value is applied to the gate of select transistor 31. A voltage under 1 volt is applied to the drain of the word select transistor 11.

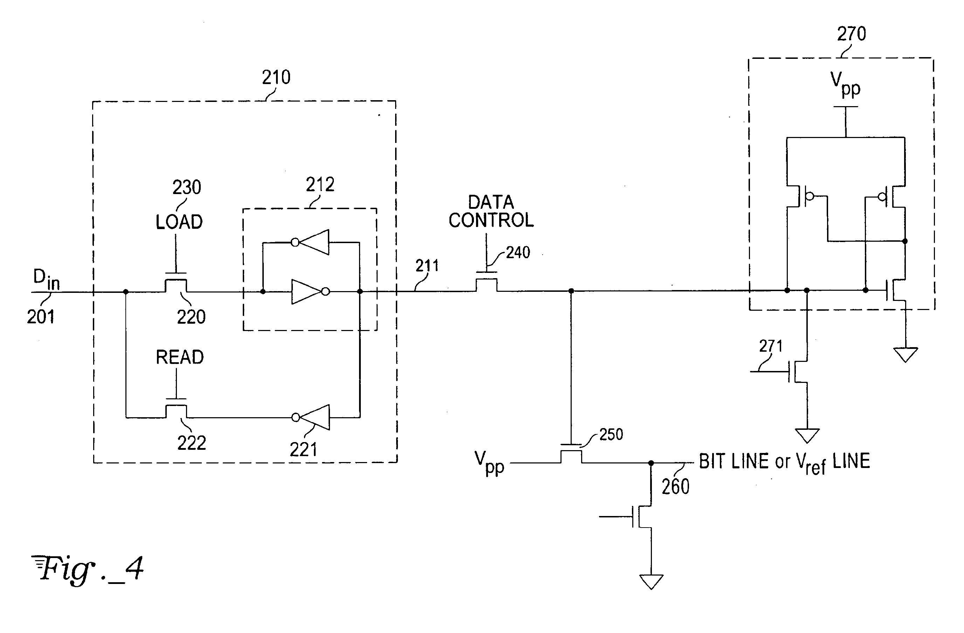

Figure 4 illustrates an exemplary embodiment of a column latch circuit 210 containing additional circuitry that may be used during a column latch read operation. In a read operation, the Xaddress decoder 130 and Yaddress decoder 120, 140 specify locations of a memory cell 30 and a column latch 210 to be read. Inverter 221 is used to isolate output line 211 from data line Din 201. This prevents connecting the output of the state latch 212 directly to the capacitive load of data line Din 201. Without inverter 221, inadvertent switching of state latch 212 may occur from a capacitive charge transfer. For the same reason, the content of state latch 212 cannot be read directly through state latch pass transistor 220. To perform a read operation of the state latch 212, a read pass transistor 222 is activated and the state of state latch 212 is read on the data line Din 201.

A verification process is executed when a memory word is read and compared to an expected logic value. For example when verifying whether a memory cell 30 has been properly erased, the expected word value is, for example, FF. In an exemplary embodiment, the comparison is performed via a dedicated comparator 103. The verification process is automatically executed after a word or plurality of words in the memory array have been erased or written. Comparator 103 (shown in Figure 2), compares an erased word's bits to a logic 1 value, and compares a written word to the content of the column latches. For a write operation verification, the logic values of programmed data have been loaded into the column latches 210 and are readable.

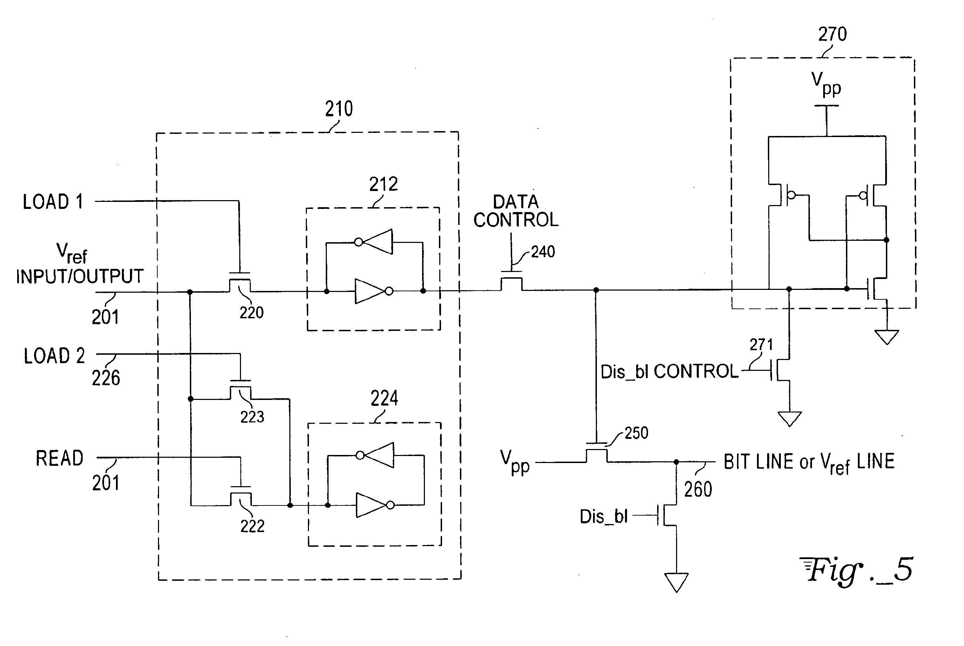

Figure 5 illustrates an exemplary embodiment of a selective V_{ref} column latch 210 that contains a separate tag latch 224. Tag latch 224 is used as a V_{ref} tag or word latch. If the V_{ref} tag has been set to a logic 1 value, the tag indicates that the corresponding memory word has been erased. Tag latch 224 may be loaded using the load tag line 226, which controls tag pass transistor 223. Load tag line 226, may be operated in conjunction with state latch load 230 to load the same state when state latch pass gate 220 is active and Din 201 is stable. Alternatively, the load tag line 226 may be used separately to load a separate tag logic value into tag latch 224. A separate read tag line 225 controlling tag pass transistor 222 reads the stored value in the tag latch 224 during a read operation.

During a verification operation performed during both the erase and write operations, a cell is read using a dedicated margin mode operation and compared to an expected logic 1 value for erased cells or alternatively, the data stored in column latches 110 for written cells. The dedicated read margin mode ensures that memory cells 30 are programmed with enough margin to maintain a set logic value over time regardless of the floating gate transistor 32 that is susceptible to natural charge variations. To verify the quality of a programming operation, V_{ref} is increased when reading OFF cells and decreased when reading ON cells. During the margin mode read operation, reference generator 154, as shown in Figure 2, generates an internal reference voltage that is higher than a voltage used in a normal read operation. For example, a margin of approximately 0.5 volts guarantees that a memory cell 30 stays OFF when reading a particular memory cell 30 with Vref+0.5 volts on its gate and stays ON when reading a particular memory cell 30 with Vref-0.5 volts on its gate.

A verification operation may be performed using more than one method. A margin mode read operation verifies that the voltage threshold Vₜₕ of each cell is high enough to overcome any floating gate variations that are related to environmental conditions (for example, temperature) or to an undesired storage of electrons (for example, trapped oxide charges.

In Figure 6, an exemplary erase algorithm using an automatic verification operation is shown. After initializing a pulse counter 310, a first erase pulse is applied 320 to the target cells 30. A verify operation 330 initializes an address counter. If memory cells 30 have been properly erased, an address counter 173 is incremented and another group of memory cells is verified. If the memory cells have not been properly erased, another pulse is applied 332, the pulse counter is incremented 332, and the memory cells are verified again 330. If a predetermined pulse counter value is reached, the verify operation 330 will stop, the erase operation will stop 331, and a program failure flag 152 will be set 333. If all of the memory cells 30 pass the erase and verification operations, a final erase pulse may optionally be applied 350.

In one embodiment, speed is optimized in the verification operation. If the comparison result confirms that the threshold voltage Vₜₕ for a verified cell or word is correct, Addyint is incremented and the next erase and verification operation is performed on the next word 330. If the threshold voltage Vₜₕ for the verified cell or word is not correct, at least one cell is not well erased. When the verify procedure fails, the erase pulse is then applied 332 again to of all the words to be programmed - even to those that successfully passed a previous verify operation. Additional erase and verify 330 operations are performed until all of the cells pass verification or until a maximum number of erase pulses have been reached. When the previously failed cells subsequently pass verification, an erase time is optimized. If the erase time maximum is reached by the verify timer 160 (in Figure 2) and the cells have not passed verification 330, the verify operation using a margin mode stops 331 and sequencer 150 (shown in Figure 1) sets 333 a programming failure flag 152. If all of the cells pass the verification operation (using a margin mode) 330, meaning that the desired erase time has been reached, a write phase then begins 410. The option of applying a final erase pulse 350 using an optimized erase time may be executed.

When the erase time has been optimized, the high voltage condition for a memory cell 30 erase has been applied to all the words to be programmed. Although this verification procedure quickly optimizes the erase time, words that have been previously erased will be erased again each time the program increments the erase time counter. The result may unnecessarily over-stress previously erased cells.

Referring again to Figure 6, an alternative embodiment of a verification operation may be implemented that avoids unnecessary stress on correctly erased words. Using the modified V_{ref} column latch 210 (shown in Figure 5), tag latch 224 (in Figure 5) stores an independent tag indicating that the word has been erased at least once. When a word address is loaded, the tag is latched as an indication that the word has not passed verification. The V_{ref} column latch will pass Vₚₚ during the first erase pulse. At the application of the first erase pulse 320, each word to be programmed is erased. Next, the words are read in margin mode during a verification operation 430. After the first erase pulse has been applied 320, the erase voltage Vₚₚ is selectively applied to only words that are not well erased (words that fail during the verification).

If a word fails a verification operation, the tag latch 212 is set to indicate a verification failure. The verification operation proceeds until all the words in memory have been verified. During a verification operation, any properly erased word will not be erased again during an application of a subsequent erase pulse 350. An erase pulse 350 will be applied to all the words in the memory core that have failed verification if at least one V_{ref} column latch data is set, meaning that at least one word is not correctly erased. When a new erase pulse is applied 350, Vₚₚ will not be applied to properly erased words because the corresponding V_{ref} column latches have been set during the verification operation. The tag latch 224 state is maintained and will be used during the verification procedure of a subsequent write phase.

As illustrated in Figure 7, during a write phase 400, the application of write voltages 420 are applied to selected cells and a write verify 430 will be performed after each writing pulse. The operation of a write verification operation is similar to the erase verification described above. The address counter 173 (in Figure 2) that provides an AddYld 171 and AddYrd 176 address is initialized 410. Similar to an erase verify operation, the V_{ref} column latch 210 or 224 is read. If the V_{ref} column latch 210 has not been set, indicating that the corresponding word is not programmed, the Y internal address is incremented. If the V_{ref} column latch 210 has been set, the content of the column latch word corresponding to the data to be written is read. The selected word in the memory core 101 that has been written is read in margin mode 430 and compared to the state of the column latch 212. To verify that ON cells are programmed with enough margin, the gates of the memory cells 32 are grounded via each pass gate 31 to each bit line.

If the latch and memory cells do not match, the comparison stops 431, indicating that at least one cell has not been correctly written. If a memory cell 30 fails the verification operation and a maximum number of verify iterations has been reached, the verify operation stops 431 and sequencer 150 (shown in Figure 1) sets 433 a programming failure flag 152.

If the contents of the latch and memory cell comparison match, the address counter 173 (in Figure 2) is incremented 432. After each verification operation, column latches 210 corresponding to the words that are correctly written can be reset in order to avoid unnecessary over-write of the word. As each memory cell passes the verification operation, the address counter is iteratively incremented 432 and another write pulse is applied 432, followed by a verify procedure 430. When all desired memory cells have passed the verify procedure, the write process ends 450.

The proposed invention is the first architecture to provide an intelligent and automatic, self-adaptive EEPROM memory cell programming operation that performs a parallel-write operation. Using specific column latches, dedicated timers, and an internally controlled verify procedure, it is possible to reduce the number of pulses and time required to complete erase and write operations. Using this method, a verification operation adapts to programming conditions such as power supply and temperature variations, individual memory cell programming variations due to cell distributions across the array, and memory cell degradation after repeated erase and write cycles. In addition, the programming power consumption may be optimized, while ensuring reliable program operations over a variety of program conditions. Finally, if a memory cell programming issue occurs, it is detected and a dedicated memory program failure flag is set.

It is to be understood that the above description is intended to be illustrative, and not restrictive. Those of skill in the art will recognize that the invention can be practiced with modification and alteration within the spirit and scope of the appended claims. Embodiment(s) of the invention so described may include a particular feature, structure, or characteristic, but not every embodiment necessarily includes the particular feature, structure, or characteristic described. Repeated use of the phrase "in one embodiment" does not necessarily refer to the same embodiment, although it may. Many other embodiments will be apparent to those of skill in the art upon reading an understanding the above description. For example, the present invention would apply to types programmable memory, other than an exemplary EEPROM. The description is thus to be regarded as illustrative instead of limiting. The scope of the invention should, therefore, be determined with reference to the appended claims, along with the full scope of equivalents to which said claims are entitled.

## Claims

1. A method of operating a memory to improve data retention in an array (101) of programmable memory cells using a verification operation to tune a programming operation, the method comprising:
defining a margin reference voltage (V_{ref}) that is different than a normal memory cell read voltage;
reading a logic value content of at least one memory cell (30) by applying said margin reference voltage (V_{ref}) to the memory cell;
comparing said logic value content of the at least one memory cell (30) to an expected logic value; and
adjusting a programming parameter to improve data retention in the at least one memory cell if said memory cell logic value content is different from said expected logic value.

2. The method of claim 1, wherein said at least one memory cell (30) within said array (101) of programmable memory cells maintains a set logic value regardless of a natural charge variation in a floating gate.

3. The method of claim 1, wherein said margin reference voltage (V_{ref}) differs by approximately +0.5 volts compared to said normal memory cell read voltage.

4. The method of claim 1, wherein said margin reference voltage (V_{ref}) differs by approximately -0.5 volts compared to said normal memory cell read voltage.

5. The method of claim 1, wherein said margin reference voltage (V_{ref}) is higher than said normal memory cell read voltage when reading memory cells (30) expected to be in an "off" state.

6. The method of claim 1, wherein said margin reference voltage is lower than said normal memory cell read voltage when reading memory cells (30) expected to be in an "on" state.

7. The method of claim 1, further comprising applying an adjusted programming pulse operation to the at least one memory cell (30) within said array (101) of programmable memory cells.

8. The method of claim 1, wherein said method is performed after an erase operation has been performed.

9. The method of claim 8, wherein an adjusted programming pulse is applied to a plurality of memory cells (30) within said array (101) of programmable memory cells if said memory cell logic value content is different than said expected logic value.

10. The method of claim 8, wherein an adjusted programming pulse operation is only applied to any memory cell (30) having a different logic value content if said memory cell logic value content is different than said expected logic value.

11. The method of claim 8, wherein an indicator tag associated with said memory cell (30) having a different logic value is latched if said memory cell logic value content is different than said expected logic value.

12. The method of claim 1, wherein said method is performed after a write operation has been performed.

13. The method of claim 12, wherein an adjusted programming pulse is applied to a plurality of memory-cells (30) within said array (101) of programmable memory cells if said memory cell logic value content is different than said expected logic value.

14. The method of claim 12, wherein an adjusted programming pulse is only applied to any memory cell (30) having a different logic value content if said memory cell logic value content is different than said expected logic value.

15. The method of claim 12, wherein an indicator tag associated with said memory cell (30) having a different logic value is latched if said memory cell logic value content is different than said expected logic value.

16. The method of claim 1, wherein adjusting said programming parameter is defined as increasing a pulse duration.

17. A programmable memory circuit comprising:
an array (101) of memory cells, said memory cells (30) capable of storing at least one logic value,
an address circuit (120, 130, 140) coupled to said array (101) of memory cells, said address circuit (120, 130, 140) capable of selecting at least one memory cell (30);
at least one voltage reference generator (153) coupled to said array (101) of memory cells, said generator (153) capable of providing a range of voltages;
a plurality of latch circuits (110) coupled to said array (101) of memory cells, said latch circuit (110) capable of storing at least one expected logic value and at least one state latch;
a sense circuit (105) coupled to said at least one memory cell (30); and
a sequencer (150) defining an address value used by said address circuit (120, 130, 140);
**characterized by**
at least one comparator (103) coupled to said sense circuit (105);
wherein the sequencer (150) is configured to define a margin reference voltage (V_{ref}) which is different than a normal memory cell read voltage, to read a memory cell by applying said margin reference voltage to said memory cell and to adjust a programming parameter to improve data retention in the memory cell if its logic value content is different from said expected logic value.

18. The programmable memory of claim 17, wherein said sequencer (150) is a state machine configured to monitor input states and generate output states in response to said input states.

19. The programmable memory of claim 17, wherein said sequencer (150) is a processor configured to execute a plurality of instructions.

## Patentansprüche

1. Verfahren zum Betreiben eines Speichers zur Verbesserung der Datenhaltung in einem Array (101) aus programmierbaren Speicherzellen unter Anwendung einer Verifizierungsoperation zur Feineinstellung eines Programmiervorgangs, wobei das Verfahren umfasst:
Definieren einer Grenzreferenzspannung (V_{ref}), die sich von einer normalen Speicherzellenlesespannung unterscheidet;
Auslesen eines Logikwertinhalts mindestens einer Speicherzelle (30) durch Anlegen der Grenzreferenzspannung (V_{ref}) an die Speicherzelle;
Vergleichen des Logikwertinhalts der mindestens einen Speicherzelle (30) mit einem erwarteten Logikwert; und
Einstellen eines Programmparameters zur Verbesserung der Datenhaltung in der mindestens einen Speicherzelle, wenn der Speicherzellen-Logikwertinhalt sich von dem erwarteten Logikwert unterscheidet.

2. Verfahren nach Anspruch 1, wobei die mindestens eine Speicherzelle (30) in dem Array (101) aus programmierbaren Speicherzellen einen eingestellten Logikwert unabhängig von einer natürlichen Ladungsänderung in einem potenzialfreien Gate beibehält.

3. Verfahren nach Anspruch 1, wobei die Grenzreferenzspannung (V_{ref}) um ungefähr +0,5 V zu der normalen Speicherzellenlesespannung differiert.

4. Verfahren nach Anspruch 1, wobei die Grenzreferenzspannung (V_{ref}) um ungefähr -0,5 V zu der normalen Speicherzellenlesespannung differiert.

5. Verfahren nach Anspruch 1, wobei die Grenzreferenzspannung (V_{ref}) höher ist als die normale Speicherzellenlesespannung, wenn Speicherzellen (30) gelesen werden, von denen angenommen wird, dass sie in einem "Aus-" Zustand sind.

6. Verfahren nach Anspruch 1, wobei die Grenzreferenzspannung kleiner ist als die normale Speicherzellenlesespannung, wenn Speicherzellen (30) gelesen werden, von denen erwartet wird, dass sie in einem "Ein-" Zustand sind.

7. Verfahren nach Anspruch 1, das ferner umfasst: Anwenden einer eingestellten Programmierpulsoperation auf die mindestens eine Speicherzelle (30) in dem Array (101) aus programmierbaren Speicherzellen.

8. Verfahren nach Anspruch 1, wobei das Verfahren ausgeführt wird, nachdem ein Löschvorgang ausgeführt worden ist.

9. Verfahren nach Anspruch 8, wobei ein eingestellter Programmierpuls an mehrere Speicherzellen (30) innerhalb des Arrays (101) aus programmierbaren Speicherzellen angelegt wird, wenn der Speicherzellen-Logikwertinhalt sich von dem erwarteten Logikwert unterscheidet.

10. Verfahren nach Anspruch 8, wobei eine eingestellte Programmierpulsoperation nur auf eine Speicherzelle (30) mit unterschiedlichem Logikwertinhalt angewendet wird, wenn der Speicherzellen-Logikwertinhalt sich von dem erwarteten Logikwert unterscheidet.

11. Verfahren nach Anspruch 8, wobei eine Indikatormarke, die mit der Speicherzelle (30) mit unterschiedlichem Logikwert verknüpft ist, gesetzt wird, wenn der Speicherzellen-Logikwertinhalt sich von dem erwarteten Logikwert unterscheidet.

12. Verfahren nach Anspruch 1, wobei das Verfahren ausgeführt wird, nachdem eine Schreiboperation ausgeführt worden ist.

13. Verfahren nach Anspruch 12, wobei ein eingestellter Programmierpuls an mehrere Speicherzellen (30) innerhalb des Arrays (101) aus programmierbaren Speicherzellen angelegt wird, wenn der Speicherzellen-Logikwertinhalt sich von dem erwarteten Logikwert unterscheidet.

14. Verfahren nach Anspruch 12, wobei ein eingestellter Programmierpuls nur an eine Speicherzelle (30) mit unterschiedlichem Logikwertinhalt angelegt wird, wenn der Speicherzellen-Logikwertinhalt sich von dem erwarteten Logikwert unterscheidet.

15. Verfahren nach Anspruch 12, wobei eine Indikatormarke, die mit der Speicherzelle (30) mit unterschiedlichem Logikwert verknüpft ist, gesetzt wird, wenn der Speicherzellen-Logikwertinhalt sich von dem erwarteten Logikwert unterscheidet.

16. Verfahren nach Anspruch 1, wobei Einstellen des Programmierparameters als Erhöhung einer Pulsdauer definiert wird.

17. Programmierbare Speicherschaltung mit:
einem Array (101) aus Speicherzellen, wobei die Speicherzellen (30) zur Speicherung mindestens eines Logikwertes in der Lage sind,
einer Adressenschaltung (120, 130, 140), die mit dem Array (101) aus Speicherzellen verbunden ist, wobei die Adressenschaltung (120, 130, 140) in der Lage ist, mindestens eine Speicherzelle (30) auszuwählen;
mindestens einem Spannungsreferenzgenerator (153), der mit dem Array (101) aus Speicherzellen verbunden ist, wobei der Generator (153) ausgebildet ist, einen Bereich an Spannungen bereitzustellen;
mehreren Signalspeicherschaltungen (110), die mit dem Array (101) aus Speicherzellen verbunden sind, wobei die Signalspeicherschaltung (110) ausgebildet ist, mindestens einen erwarteten Logikwert und mindestens einen Zustandspeicherwert zu speichern;
einer Erfassungsschaltung (105), die mit der mindestens einen Speicherschaltung (30) verbunden ist; und
einer Sequenzier-Einheit (150), die einen Adressenwert festlegt, der von der Adressenschaltung (120, 130, 140) verwendet ist;
**gekennzeichnet durch**
mindestens einen Komparator (103), der mit der Erfassungsschaltung (105) verbunden ist;
wobei die Sequenzier-Einheit (150) ausgebildet ist, eine Grenzreferenzspannung (V_{ref}) festzulegen, die sich von einer normalen Speicherzellenlesespannung unterscheidet, eine Speicherzelle auszulesen, indem die Grenzreferenzspannung an die Speicherzelle angelegt wird, und einen Programmierparameter einzustellen, um die Datenhaltung in der Speicherzelle zu verbessern, wenn ihr Logikwertinhalt sich von dem erwarteten Logikwert unterscheidet.

18. Programmierbare Speicherschaltung nach Anspruch 17, wobei die Sequenzier-Einheit (150) eine Zustandsmaschine ist, die ausgebildet ist, Eingangszustände zu überwachen und Ausgangszustände in Reaktion auf die Eingangszustände zu erzeugen.

19. Programmierbare Speicherschaltung nach Anspruch 17, wobei die Sequenzier-Einheit (150) ein Prozessor ist, der ausgebildet ist, mehrere Befehle auszuführen.

## Revendications

1. Procédé de fonctionnement d'une mémoire permettant d'améliorer la rétention de données dans une matrice (101) de cellules de mémoire programmables en utilisant une opération de vérification pour accorder une opération de programmation, le procédé comprenant :
la définition d'une tension de référence de marge (V_{ref}) qui est différente d'une tension de lecture de cellule de mémoire normale ;
la lecture d'un contenu de valeur logique d'au moins une cellule de mémoire (30) en appliquant ladite tension de référence de marge (V_{ref}) à la cellule de mémoire ;
la comparaison dudit contenu de valeur logique de l'au moins une cellule de mémoire (30) avec une valeur logique attendue ; et
le réglage d'un paramètre de programmation pour améliorer la rétention de données dans l'au moins une cellule de mémoire si ledit contenu de valeur logique de cellule de mémoire est différent de ladite valeur logique attendue.

2. Procédé selon la revendication 1, dans lequel ladite au moins une cellule de mémoire (30) dans ladite matrice (101) de cellules de mémoire programmables maintient une valeur logique déterminée quelle que soit la variation de charge naturelle d'une grille flottante.

3. Procédé selon la revendication 1, dans lequel ladite tension de référence de marge (V_{ref}) diffère approximativement de +0,5 V de ladite tension de lecture de cellule de mémoire normale.

4. Procédé selon la revendication 1, dans lequel ladite tension de référence de marge (V_{ref}) diffère approximativement de -0,5 V de ladite tension de lecture de cellule de mémoire normale.

5. Procédé selon la revendication 1, dans lequel ladite tension de référence de marge (V_{ref}) est supérieure à ladite tension de lecture de cellule de mémoire normale lorsqu'on s'attend à ce que la lecture des cellules de mémoire (30) soit dans un état « arrêt ».

6. Procédé selon la revendication 1, dans lequel ladite tension de référence de marge est inférieure à ladite tension de lecture de cellule de mémoire normale lorsqu'on s'attend à ce que la lecture des cellules de mémoire (30) soit dans un état « marche ».

7. Procédé selon la revendication 1, comprenant en outre l'application d'une opération d'impulsion de programmation réglée à l'au moins une cellule de mémoire (30) dans ladite matrice (101) de cellules de mémoire programmable.

8. Procédé selon la revendication 1, dans lequel ledit procédé est exécuté après avoir effectué une opération d'effacement.

9. Procédé selon la revendication 8, dans lequel une impulsion de programmation réglée est appliquée à une pluralité de cellules de mémoire (30) dans ladite matrice (101) de cellules de mémoire programmables si ledit contenu de valeur logique de cellule de mémoire est différent de ladite valeur logique attendue.

10. Procédé selon la revendication 8, dans lequel une opération d'impulsion de programmation réglée est appliquée uniquement à une quelconque cellule de mémoire (30) ayant un contenu de valeur logique différent si ledit contenu de valeur logique de cellule de mémoire est différent de ladite valeur logique attendue.

11. Procédé selon la revendication 8, dans lequel une étiquette indicatrice associée avec ladite cellule de mémoire (30) ayant une valeur logique différente est bloquée si ledit contenu de valeur logique de cellule de mémoire est différent de ladite valeur logique attendue.

12. Procédé selon la revendication 1, dans lequel ledit procédé est exécuté après avoir effectué une opération d'écriture.

13. Procédé selon la revendication 12, dans lequel une impulsion de programmation réglée est appliquée à une pluralité de cellules de mémoire (30) dans ladite matrice (101) de cellules de mémoire programmables si ledit contenu de valeur logique de cellule de mémoire est différent de ladite valeur logique attendue.

14. Procédé selon la revendication 12, dans lequel une impulsion de programmation réglée est appliquée uniquement à une quelconque cellule de mémoire (30) ayant un contenu de valeur logique différent si ledit contenu de valeur logique de cellule de mémoire est différent de ladite valeur logique attendue.

15. Procédé selon la revendication 12, dans lequel une étiquette indicatrice associée avec ladite cellule de mémoire (30) ayant une valeur logique différente est bloquée si ledit contenu de valeur logique de cellule de mémoire est différent de ladite valeur logique attendue.

16. Procédé selon la revendication 1, dans lequel le réglage dudit paramètre de programmation est défini par l'augmentation de la durée d'impulsion.

17. Circuit de mémoire programmable comprenant :
une matrice (101) de cellules de mémoire, lesdites cellules de mémoire (30) étant capable de mémoriser au moins une valeur logique,
un circuit d'adresse (120, 130, 140) couplé à ladite matrice (101) de cellules de mémoire, ledit circuit d'adresse (120, 130, 140) étant capable de sélectionner au moins une cellule de mémoire (30) ;
au moins un générateur de référence de tension (153) couplé à ladite matrice (101) de cellule de mémoire, ledit générateur (153) étant capable de fournir une plage de tensions ;
une pluralité de circuits de verrouillage (110) couplés à ladite matrice (101) de cellules de mémoire, ledit circuit de verrouillage (110) étant capable de mémoriser au moins une valeur logique attendue et au moins un verrouillage d'état ;
un circuit de lecture (105) couplé à ladite au moins une cellule de mémoire (30) ; et
un séquenceur (150) définissant une valeur d'adresse utilisée par ledit circuit d'adresse (120, 130, 140) ;
**caractérisée par**
au moins un comparateur (103) couplé audit circuit de lecture (105) ;
dans laquelle le séquenceur (150) est configuré pour définir une tension de référence de marge (V_{ref}) qui est différente d'une tension de lecture de cellule de mémoire normale, pour lire une cellule de mémoire en appliquant ladite tension de référence de marge à ladite cellule de mémoire et pour régler un paramètre de programmation pour améliorer la rétention de données dans la cellule de mémoire si son contenu de valeur logique est différent de ladite valeur logique attendue.

18. Mémoire programmable selon la revendication 17, dans laquelle ledit séquenceur (150) est une machine d'état configurée pour surveiller les états d'entrée et générer des états de sortie en réponse auxdits états d'entrée.

19. Mémoire programmable selon la revendication 17, dans laquelle ledit séquenceur (150) est un processeur configuré pour exécuter une pluralité d'instructions.
